# FASCICULE DE BREVET EUROPEEN

(11) **EP 4 264 677 B1**
(45) Date de publication et mention de la délivrance du brevet: **06.11.2024**
(21) Numéro de dépôt: 21848274.3
(22) Date de dépôt: 13.12.2021
(51) Int. Cl.: H01L 31/0725, H01L 31/0747

(54) **STRUCTURE SIMPLIFIEE DE CELLULES SOLAIRES TANDEM A DEUX TERMINAUX AYANT UN MATERIAU DE JONCTION EN OXYDE TRANSPARENT CONDUCTEUR**
VEREINFACHTE STRUKTUR VON DOPPELPOL-TANDEMSOLARZELLEN MIT TRANSPARENTEM LEITFÄHIGEM OXIDVERBINDUNGSMATERIAL
SIMPLIFIED STRUCTURE OF TWO-TERMINAL TANDEM SOLAR CELLS WITH TRANSPARENT CONDUCTING OXIDE JUNCTION MATERIAL

(30) Priorité: 18.12.2020 FR 2013592
(43) Date de publication de la demande: 25.10.2023
(73) Titulaire: Commissariat à l'Energie Atomique et aux Energies Alternatives, 75015 Paris (FR); 3SUN S.r.l., 95121 Catania (CT) (IT)
(72) Inventeur: PUAUD, Apolline, 38054 GRENOBLE CEDEX 09 (FR); MATHERON, Muriel, 38054 GRENOBLE CEDEX 09 (FR); MUNOZ, Maria-Delfina, 38054 GRENOBLE CEDEX 09 (FR)
(74) Mandataire: Brevalex
(86) Numéro de dépôt international: PCT/FR2021/052295
(87) Numéro de publication internationale: WO 2022/129757

(56) Documents cités:
- CN-A- 107 369 767
- CN-A- 111 554 764
- CN-U- 209 016 100
- US-A1- 2018 174 761
- US-A1- 2018 175 112
- US-A1- 2019 221 690
- US-B2- 10 622 409

## Description

### DOMAINE TECHNIQUE

La présente invention se rapporte au domaine des dispositifs photovoltaïques, en particulier des cellules photovoltaïques de type tandem pérovskite sur hétérojonction de silicium à 2 terminaux.

L'invention concerne une structure simplifiée ayant des propriétés (photo)électriques comparables à celles d'une structure tandem classique.

### ÉTAT DE LA TECHNIQUE ANTÉRIEURE

Les cellules solaires permettent de convertir une partie du domaine spectral du rayonnement solaire en énergie. Pour augmenter le rendement de cette conversion, il est possible de fabriquer des structures à architecture tandem comprenant deux sous-ensembles (i.e. une cellule inférieure et une cellule supérieure), absorbant dans des domaines spectraux différents.

De nombreuses configurations sont possibles. La cellule inférieure 10 peut être, par exemple, une cellule en pérovskite, en CIGS (Cu(In,Ga)Se₂), ou encore il peut s'agir d'une cellule à base de silicium, par exemple, à homojonction ou à hétérojonction de silicium (HET-Si ou SHJ pour « Silicon HeteroJunction solar cell »), de type PERC (« Passivated Emitter and Rear Contact ») ou TopCon (« Tunnel Oxide Passivated Contact ») ou encore une cellule PERT type N avec double diffusion de phosphore.

La cellule supérieure 30 peut être, par exemple, une cellule pérovskite, organique ou multi-jonction (MJSC) à base de matériaux III-V (AlGaAs, GalnP, GaAs).

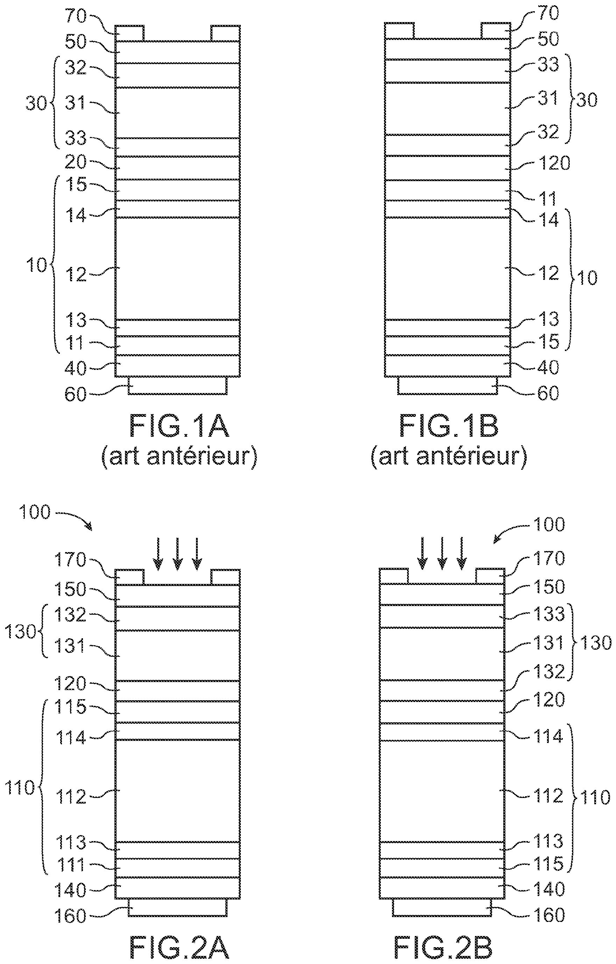

Les deux sous-cellules peuvent être empilées l'une sur l'autre selon un schéma NIP/NIP (figure 1A) ou PIN/PIN (figure 1B).

A titre illustratif, dans le cas des structures tandem de type perovskite sur hétérojonction de silicium à 2-terminaux, la structure de type NIP comprend classiquement de la face arrière vers la face avant (figure 1A) :
- une cellule inférieure 10 comprenant une couche de silicium amorphe dopé N 11, un substrat en silicium cristallin 12 disposé entre deux couches de silicium amorphe intrinsèques 13, 14, une couche de silicium amorphe dopé P 15, - une zone de recombinaison 20,
- une cellule supérieure 30 comprenant : une couche de type N 33, une couche active en un matériau pérovskite 31, une couche de type P 32.

Des électrodes inférieure 40 et supérieure 50 ainsi que des contacts électriques 60, 70 viennent compléter la structure.

Dans le cas d'une structure de type PIN, les couches de type P et N sont inversées (figure 1B). Un exemple d'une telle structure photovoltaïque tandem est décrit dans la figure 1 de CN 111554764 A.

Chaque sous-cellule 10, 30 de la structure tandem comporte des couches qui permettent de séparer et sélectionner les charges selon leur polarité.

La zone de recombinaison 20 entre les deux sous-cellules est nommée « jonction de recombinaison » car elle permet aux charges de se recombiner. Généralement, elle est formée d'une couche d'oxyde conducteur transparent ou d'une jonction tunnel (deux couches très dopées, l'une de type N et l'autre de type P). Cette zone de recombinaison permet la connexion en série des sous-cellules et ainsi l'addition de leurs tensions. Elle doit entraîner la recombinaison des électrons générés dans la cellule supérieure 30 et des trous générés dans la cellule inférieure 10 pour un tandem de structure NIP (Fig.1A) et l'inverse pour une structure PIN (Fig.1B).

Cependant, ces structures tandem nécessitent de nombreuses étapes pour être fabriquées, ce qui augmente les coûts de fabrication et le nombre de couches et d'interfaces susceptibles de baisser les performances (par ajout de résistance série, de résistances de contact, de recombinaisons non souhaitées...).

Il a été montré qu'une structure tandem de type NIP comprenant une cellule supérieure pérovskite et une cellule inférieure à base de silicium cristallin et de poly-Si peut fonctionner en positionnant directement la cellule supérieure sur la cellule inférieure (Shen et al. « In situ recombination junction between p-Si and TiO2 enables high-efficiency monolithic perovskite/Si tandem cells », Science Advances, 2018; 4: eaau9711). Plus particulièrement, une couche de TiOz de type N est déposée par ALD directement sur le silicium dopé P de la cellule inférieure. Puis, une couche de pérovskite et une couche de type P en PTAA sont déposées. Le fonctionnement de cette structure est rendu possible grâce à la faible résistivité de contact entre la couche ALD de TiOz et le silicium dopé P de la cellule inférieure.

De même, une structure tandem pérovskite sur homojonction de silicium a été fabriquée en déposant directement la couche de SnOz de type N de la cellule supérieure en pérovskite sur la couche de type P de la cellule inférieure (Zheng et al. "Large area efficient interface layer free monolithic perovskite/homo-junction-silicon tandem solar cell with over 20% efficiency", Energy Environ. Sci., 2018, 11, 2432-2443).

Cependant, à ce jour, il n'existe pas de structure tandem pérovskite sur hétérojonction de silicium, à base de silicium amorphe et de silicium cristallin, simplifiée. En effet, l'hétérojonction silicium amorphe/silicium cristallin est très sensible à la température utilisée lors du procédé. De plus, le dépôt de la couche active de pérovskite est généralement réalisé par voie liquide et est donc grandement dépendant du substrat sur lequel elle est déposée ainsi que des étapes de fabrication mises en oeuvre, ce qui rend une modification de leur architecture très difficile à réaliser.

### EXPOSÉ DE L'INVENTION

Un but de la présente invention est de proposer une structure tandem pérovskite sur hétérojonction de silicium à base de silicium amorphe et de silicium cristallin à deux terminaux présentant de bonnes propriétés électriques et plus simple et moins coûteuse à fabriquer.

Pour cela, la présente invention propose une structure tandem à 2-terminaux comprenant les caractéristiques de la revendication 1.

L'invention se distingue fondamentalement de l'art antérieur par l'utilisation d'un matériau de jonction en oxyde transparent conducteur (OTC ou TCO pour « Transparent Conductive Oxides ») qui joue non seulement le rôle de jonction de recombinaison mais également celui de sélection des charges (contact de type N) pour l'une des cellules dans la structure tandem. Ainsi, la structure tandem fonctionne, même si l'une des deux sous-cellules est dépourvue d'une couche de type N ; la fonction de cette couche de type N étant alors assurée par la couche en oxyde transparent conducteur elle-même.

Cette structure simplifiée est plus simple à fabriquer par rapport aux structures solaires tandem classiques. La diminution du nombre d'étapes du procédé de fabrication conduit à une réduction des coûts de fabrication.

Selon une première variante de réalisation ne faisant pas partie de l'invention, la structure tandem est de type NIP. La deuxième cellule est dépourvue de la couche de type N. Autrement dit, la deuxième cellule est formée de la couche active en un matériau pérovskite et la deuxième couche de type P. La couche active en un matériau pérovskite est alors en contact direct avec la couche de jonction en TCO qui joue ainsi le rôle de couche de type N pour la structure tandem de type NIP.

Selon cette première variante de réalisation, la structure peut comprendre depuis la face arrière vers la face avant :
- la première cellule solaire à hétérojonction de silicium à base de silicium amorphe et de silicium cristallin comprenant depuis la face arrière vers la face avant :
   - une couche de silicium amorphe dopé N, la première couche de silicium amorphe intrinsèque, le substrat de silicium cristallin, la deuxième couche de silicium amorphe intrinsèque, et la première couche de type P en silicium amorphe dopé,
- la couche de jonction en TCO de type N,
- la deuxième cellule solaire de type pérovskite comprenant depuis la couche de jonction vers la face avant : la couche active en un matériau pérovskite et la deuxième couche de type P, de préférence en PTAA.

Une telle architecture présente plusieurs avantages : l'interface (p)a-Si :H/TCO présente de bonnes propriétés de recombinaison et comme l'empilement de la cellule inférieure est homogène, le dépôt de la couche pérovskite sur le TCO est également homogène.

Selon l'invention, la structure tandem est de type PIN. La première cellule est dépourvue d'une couche de type N : la première cellule est formée du substrat en silicium cristallin, recouvert de part et d'autre par une couche de silicium amorphe intrinsèque, et la couche de type P (la couche de type P est la première couche de l'empilement en partant de la face arrière). Il n'y a pas de couche de type N entre le substrat en silicium cristallin et la couche de jonction en TCO : la couche de jonction est en contact direct avec la deuxième couche de silicium amorphe intrinsèque.

Selon cette deuxième variante de réalisation, la structure peut comprendre depuis la face arrière vers la face avant :
- la première cellule solaire à hétérojonction de silicium à base de silicium amorphe et de silicium cristallin comprenant depuis la face arrière vers la face avant : la première couche de type P en silicium amorphe dopé, la première couche de silicium amorphe intrinsèque, le substrat de silicium cristallin, la deuxième couche de silicium amorphe intrinsèque,- la couche de jonction en TCO de type N,
- la deuxième cellule solaire de type pérovskite comprenant depuis la couche de jonction vers la face avant : une couche de P, de préférence en PTAA ou en TFB, la couche active en un matériau pérovskite et une couche de type N, de préférence en SnO₂ ou formée d'un bicouche PCBM/SnO₂ ou PCBM/BCP.

La cellule supérieure de type pérovskite est ici une cellule classique (i.e. la couche de pérovskite est déposée sur la couche de type P). Une telle cellule est connue et peut être réalisée facilement avec des procédés classiques.

Avantageusement, la couche de jonction a une épaisseur de 2 à 30 nm.

Avantageusement, la couche de jonction a une conductivité de supérieure à 10 S.cm⁻¹.

Selon une variante avantageuse de réalisation, la couche de jonction est en ITO.

Selon une autre variante avantageuse de réalisation, la couche de jonction est en AZO, ZnO, IWO, IZO, IZrO ou SnO₂₋ₓ avec x supérieur à 0 et strictement inférieur à 2.

Avantageusement, le matériau pérovskite a pour formule CsₓFA₁₋ₓPb(I_{1-y}Br_{y})₃ (avec x < 0,20 ; 0 < y < 1).

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1A déjà commentée dans l'art antérieur, représente, de manière schématique et en coupe, une structure tandem de type NIP à deux terminaux.
La figure 1B déjà commentée dans l'art antérieur, représente, de manière schématique et en coupe, une structure tandem de type PIN à deux terminaux.
La figure 2A représente, de manière schématique et en coupe, une structure tandem simplifiée de type NIP à deux terminaux, selon un mode de réalisation ne faisant pas partie de l'invention.
La figure 2B représente, de manière schématique et en coupe, une structure tandem simplifiée de type PIN à deux terminaux, selon l'invention.

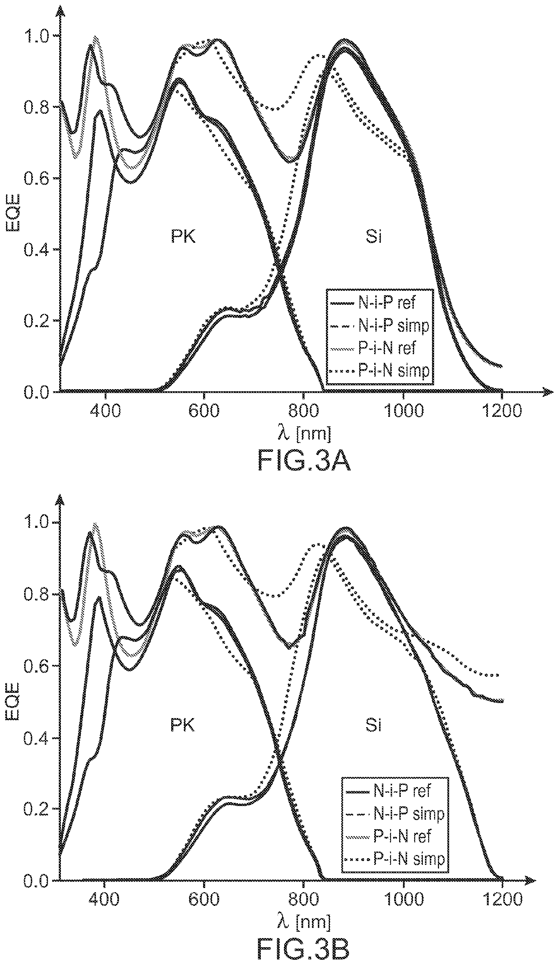

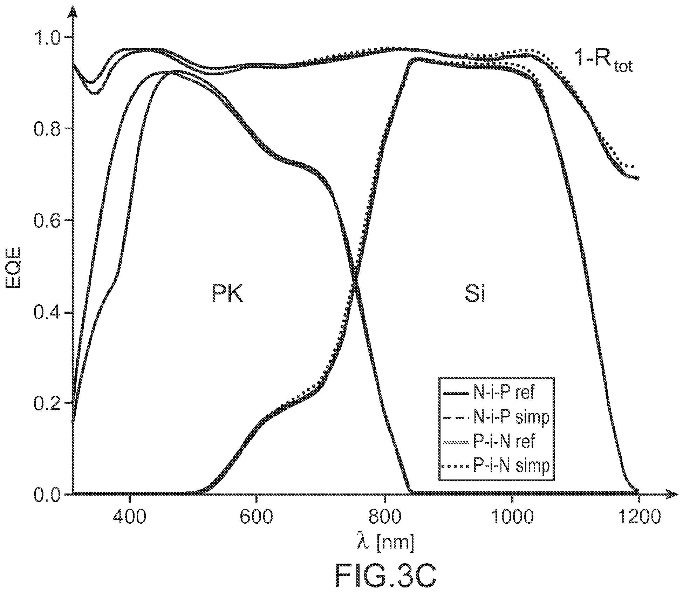

Les figures 3A, 3B et 3C sont des graphiques représentant l'EQE et la valeur '1-Rtot' en fonction de la longueur d'onde (avec Rtot correspondant à la réflexion totale de l'empilement de la cellule (sans la métallisation en face avant), obtenus par simulation optique pour des structures tandems avec une jonction en ITO fin (12 nm), de type PIN ou NIP, et ayant, respectivement soit deux faces polies, soit une face arrière texturée soit les deux faces texturées ; 'ref' correspond à des structures tandem classiques et 'simp' à des structures tandem simplifiées, selon des modes de réalisation particuliers de l'invention ; les structures tandem simplifiées se différencient des structures classiques par l'absence d'une couche de polarité N dans l'une des sous-cellules.

Les différentes parties représentées sur les figures ne le sont pas nécessairement selon une échelle uniforme, pour rendre les figures plus lisibles.

Dans la description ci-après, des termes qui dépendent de l'orientation, tels que « dessus » / « supérieure », «dessous » / « inférieure », etc. d'une structure s'appliquent en considérant que le dispositif tandem et la structure test sont orientés de la façon illustrée sur les figures.

### EXPOSÉ DÉTAILLÉ DE MODES DE RÉALISATION PARTICULIERS

On se réfère tout d'abord aux figures 2A et 2B qui représentent des structures tandem 100 simplifiées.

Les structures tandem 100 comprennent depuis la face arrière vers la face avant (i.e. la face destinée à recevoir le rayonnement lumineux représenté par des flèches) un empilement multicouche formant :
- une première cellule 110 (ou cellule inférieure pour « bottom cell ») à hétérojonction de silicium (HET-Si ou SHJ pour « Silicon HeteroJunction solar cell ») à base de silicium amorphe et de silicium cristallin, positionnée en face arrière,
- une couche de jonction 120 en oxyde transparent conducteur (aussi dite couche de jonction et de recombinaison), servant à contacter électriquement les deux sous-cellules de la structure tandem 100 et permettant aux charges de se recombiner,
- une deuxième cellule 130 (ou cellule supérieure pour « top cell ») de type pérovskite positionnée en face avant.

La structure tandem 100 peut être une structure de type NIP (figure 2A) ou de type PIN (figure 2B).

Plus particulièrement, la structure de type NIP (ou à émetteur standard) comprend depuis la face arrière vers la face avant (figure 2A):
- une première cellule solaire 110 à hétérojonction de silicium ; à base de silicium amorphe et de silicium cristallin ; et comprenant depuis la face arrière vers la face avant : une couche de silicium amorphe dopé N (aussi appelée couche de silicium amorphe hydrogéné dopé n et également notée (n) a-Si :H) 111, un substrat de silicium cristallin dopé 112 (typiquement un substrat de silicium cristallin dopé n également noté c-Si (n)) disposé entre deux couches de silicium amorphe intrinsèque 113, 114 (également appelées couches de (i) a-Si :H ou de silicium amorphe hydrogéné intrinsèque), et une couche de silicium amorphe dopé P (également noté (p) a-Si :H pour silicium amorphe hydrogéné dopé p) 115,
- une couche de jonction 120 en oxyde transparent conducteur de type N (également appelé par l'acronyme anglo-saxon TCO),
- une deuxième cellule solaire 130 de type pérovskite comprenant, depuis la couche de jonction 120 vers la face avant, une couche active en un matériau pérovskite 131 et une couche de type P 132.

Pour cette structure de type NIP, la couche active 131 de la deuxième cellule 130 est directement en contact avec la couche de jonction 120, il n'y donc aucune couche interposée entre les deux.

Plus particulièrement, la structure de type PIN (ou à émetteur inversé) comprend depuis la face arrière vers la face avant (figure 2B) un empilement multicouche formant :
- une première cellule solaire 110 à hétérojonction de silicium à base de silicium amorphe et de silicium cristallin comprenant depuis la face arrière vers la face avant : une couche de silicium amorphe dopé P 115 ((p) a-Si :H), une première couche de silicium amorphe intrinsèque 113 ((i) a-Si :H), un substrat de silicium cristallin dopé de type N (substrat c-Si (n)) 112 et une deuxième couche de silicium amorphe intrinsèque ((i) a-Si :H) 114,
- une couche de jonction 120 en TCO
- une deuxième cellule solaire de type pérovskite 130 comprenant depuis la couche de jonction vers la face avant : une couche de type P 132, une couche active 131 en un matériau pérovskite, une couche de type N 133.

Pour cette structure de type PIN, la deuxième couche de silicium amorphe intrinsèque 114 de la première cellule 110 est directement en contact avec la couche de jonction 120 ; il n'y a donc aucune couche interposée entre les deux.

Dans ces différentes variantes de réalisation, la couche de jonction 120 en TCO peut avoir une épaisseur de 2 à 30 nm et de préférence entre 2nm et 15nm.

La conductivité de la couche de jonction 120 en TCO est, par exemple, supérieure à 10 S.cm⁻¹.

La couche de jonction 120 peut être en oxyde d'indium-étain (ITO), oxyde de zinc (ZnO), oxyde de zinc dopé à l'aluminium (AZO), oxyde d'indium-tungstène (IWO), oxyde d'indium-zinc (IZO), oxyde d'indium dopé au zirconium (IZrO) ou du dioxyde d'étain (SnO₂₋ₓ avec 0 < x < 2).

La bande interdite de la couche de jonction 120 en TCO va de 2,8 à 4 eV.

La couche de jonction 120 en ITO a une bande de conduction de -4,2 à - 5,2 eV. Pour les autres oxydes dopés précités, la bande de conduction va de -4 à -5,2 eV.

De préférence, la couche de jonction 120 est en ITO.

Le substrat de silicium 12 de la cellule inférieure peut être poli ou texturé (par exemple, il peut s'agir d'une texturation sous la forme de pyramides de 2µm). Les couches amorphes en de la cellule inférieure ayant une épaisseur de quelques nanomètres, elles vont prendre la forme de la texturation du substrat.

Les taux de dopage de type p/n des couches 111 et 115 sont, par exemple entre 10¹⁸ et 10¹⁹ /cm³.

La couche de type N 133 de la deuxième cellule pérovskite est dite « couche de transport d'électrons » (ou EIL pour « Electron Injection Layer » ou ETL pour « Electron Transport Layer »).

La couche de type N 133 est, par exemple, un oxyde métallique tel que l'oxyde de zinc (ZnO), de l'oxyde de zinc dopé à l'aluminium aussi appelé AZO (ZnO :AI), l'oxyde de titane (TiO₂) ou l'oxyde d'étain (SnO₂). Il peut également s'agir d'un empilement de [6,6]-phényl-C₆₁-butanoate de méthyle et de SnOz (PCBM/SnO₂) ou de [6,6]-phényl-C₆₁-butanoate de méthyle et de bathocuproine (PCBM/ BCP).

Le matériau pérovskite de la couche active 131 de la deuxième cellule solaire 130 a de formule générale ABX₃ avec A représentant un ou plusieurs cations organiques monovalents, tel qu'un ammonium, comme le méthylammonium ou le formamidinium, ou encore un cation métallique monovalent, comme le césium ou le rubidium ; B représentant un cation métallique divalent comme Pb, Sn, Ag ou un de leurs mélanges; et X représentant un ou plusieurs anions halogénures.

Plus particulièrement, le matériau pérovskite peut avoir pour formule particulière H₂NCHNH₂PbX₃ ou CH₃NH₃PbX₃ avec X un halogène. Il peut s'agir par exemple de iodure de plomb méthylammonium CH₃NH₃PbI₃. De préférence, le matériau pérovskite a pour formule CsₓFA₁₋ₓPb(I_{1-y}Br_{y})₃.

La couche de type P 132 de la deuxième cellule 130 est aussi appelée « couche de transport de trous » (ou HTL pour « Hole Transport Layer »).

La couche de type P 132 est, par exemple, un composé organique comme du Poly(3,4-éthylenedioxythiophène) Polystyrene sulfonate (PEDOT:PSS), du [poly(bis 4-phényl}{2,4,6-trimethylphényl}amine)] (PTAA), du [Poly(*N,N'*-bis(4-butylphényl)-*N,N'*-bis(phényl)-benzidine] (Poly-TPD), du 2,2',7,7'-Tétrakis[N,N-di(4-méthoxyphényl)amino]-9,9'-spirobifluorène (spiro-OMeTAD), du N4,N4'-bis(4-(6-((3-éthyloxetan-3-yl)méthoxy)hexyl)phényl)-N4,N4'-diphényl-[1,1'-biphényl]-4,4'-diamine (OTPD), du poly[(9,9-dioctylfluorenyl-2,7-diyl)-co-(4,4'-(*N*-(4-*sec-*butylphenyl)diphenylamine)] (TFB) ou du pyrène, ou encore un oxyde métallique tel qu'un oxyde de molybdène, un oxyde de vanadium ou un oxyde de tungstène. Elle pourrait également être obtenue à partir de phosphonate(s), silanes ou acides carboxyliques.

La structure tandem 100 peut également comprendre :
- une première électrode 140 (électrode inférieure) disposée en face arrière ; l'électrode inférieure 140 peut, avantageusement, être opaque ou de transparence limitée, par exemple un oxyde transparent conducteur tel que notamment ITO, IOH (oxyde d'indium hydrogéné), ou AZO,
- une deuxième électrode 150 (électrode supérieure) disposée sur la face avant du dispositif; la deuxième électrode est électriquement conductrice et optiquement transparente, de manière à laisser passer les photons jusqu'à la couche active 131 de la cellule supérieure 130. Cette électrode 150 peut être en oxyde transparent conducteur, typiquement de l'oxyde d'indium-étain (ITO) ou de l'oxyde de zinc dopé à l'aluminium (ZnO :AI), ou encore elle peut être formée d'un polymère transparent conducteur comprenant des nanofils d'argent par exemple,
- des reprises de contact 160 en face arrière et des reprises de contact 170 en face avant ; les reprises de contact peuvent être par exemple en or, en aluminium ou en argent (déposé par exemple par évaporation, ou imprimé par sérigraphie, impression jet d'encre...).

### Exemples illustratifs et non limitatifs d'un mode de réalisation :

Des simulations optiques de différentes structures ont été réalisées en utilisant le logiciel CROWM, en tenant compte des indices optiques des couches, de leur épaisseur et de l'état de surface (totalement plane, texturée...). Ces simulations sont effectuées entre 310 et 1200 nm avec le spectre solaire AM1.5. Les indices optiques ont été extraits par ellipsométrie à partir des couches expérimentales.

Le Tableau 1 répertorie les épaisseurs (nm) des couches simulées pour les architectures de type NIP.

| | **Structure de référence NIP** | **Structure simplifiée NIP** |
|---|---|---|
| **ITO face avant** | 180 | 180 |
| **PTAA** | 30 | 30 |
| **Pérovskite** | 250 et 415 | 250 et 415 |
| **SnO₂** | 30 | - |
| **Couche de jonction en ITO rec.** | 12 | 12 |
| **a-Si:H (p)** | 19 | 19 |
| **a-Si:H (i)** | 5 | 5 |
| **c-Si** | 280000 | 280000 |
| **a-Si:H (i)** | 5 | 5 |
| **a-Si:H (n)** | 8 | 8 |
| **ITO face arrière** | 70 | 70 |
| **Ag** | 200 | 200 |

Le Tableau 2 répertorie les épaisseurs (nm) des couches simulées pour les architectures de type PIN.

| | **Structure de référence PIN** | **Structure simplifiée PIN** |
|---|---|---|
| **ITO face avant** | 180 | 180 |
| **SnO₂** | 30 | 30 |
| **Couche active en pérovskite** | 250 et 415 | 250 et 415 |
| **PTAA** | 30 | 30 |
| **Couche de jonction en ITO rec.** | 12 | 12 |
| **a-Si:H (n)** | 8 | - |
| **a-Si:H (i)** | 5 | 5 |
| **c-Si** | 280000 | 280000 |
| **a-Si:H (i)** | 5 | 5 |
| **a-Si:H (p)** | 19 | 19 |
| **ITO face arrière** | 70 | 70 |
| **Ag** | 200 | 200 |

La pérovskite utilisée dans les simulations est de type CsₓFA₁₋ₓPb(I_{1-y}Br_{y})₃ (avec x < 0,20 ; 0 < y < 1), deux épaisseurs différentes ont été utilisées pour obtenir moins d'écart de courant entre les deux sous-cellules lorsque l'état de surface est modifié.

Les figures 3A, 3B et 3C représentent les valeurs de EQE et 1-Rtot obtenus par simulations optiques pour les différentes structures tandems des tableaux 1 et 2.

Les résultats présentés correspondent à des structures tandem dont la couche active de la cellule supérieure est un matériau pérovskite de 250 nm d'épaisseur lorsque la face avant est polie et de 415 nm d'épaisseur lorsqu'elle est texturée.

Cette étude par simulation optique démontre que les structures tandem simplifiées NIP et PIN avec une jonction en ITO fine sont viables peu importe la texturation. En effet, ces structures simplifiées ne présentent optiquement que très peu de différences avec les structures complètes classiques et ont le même potentiel optique.

De plus, le tableau 3 suivant donne les valeurs de J_{sc} et Rₜₒₜ obtenus par simulations optiques, PCE estimés pour FF = 75% et V_{oc}=1.8 V. Ce tableau montre que les courants de court-circuit qui en résultent sont très similaires.

| Face avant | Face arrière | NIP/PIN | Figure | J_{sc} PK (mA/cm²) | J_{sc} Si (mA/cm²) | PCE (%) | Rₜₒₜ (mA/cm²) |
|---|---|---|---|---|---|---|---|
| Structure tandem de référence | | | | | | | |
| polie | texturée | NIP | 1A | 16.95 | 16.58 | 22.38 | 9.2 |
| polie | texturée | PIN | 1B | 16.93 | 16.79 | 22.67 | 9.69 |
| polie | polie | NIP | 1A | 16.95 | 15.79 | 21.32 | 11.41 |
| polie | polie | PIN | 1B | 16.93 | 16.09 | 21.72 | 11.83 |
| texturée | texturée | NIP | 1A | 19.67 | 20 | 26.55 | 2.9 |
| texturée | texturée | PIN | 1B | 19.99 | 20.1 | 26.99 | 3.06 |

| Structure tandem simplifiée | | | | | | | |
|---|---|---|---|---|---|---|---|
| polie | texturée | NIP | 2A | 16.58 | 17.16 | 22.38 | 8.73 |
| polie | texturée | PIN | 2B | 16.91 | 16.88 | 22.79 | 9.67 |
| polie | polie | NIP | 2A | 16.58 | 16.36 | 22.09 | 11.18 |
| polie | polie | PIN | 2B | 16.91 | 16.13 | 21.78 | 11.85 |
| texturée | texturée | NIP | 2A | 19.42 | 20.32 | 26.22 | 2.69 |
| texturée | texturée | PIN | 2B | 19.99 | 20.12 | 26.99 | 3.05 |

## Revendications

1. Structure photovoltaïque tandem (100) à 2-terminaux de type PIN comprenant depuis la face arrière vers la face avant :
- une première cellule solaire (110) à hétérojonction de silicium comprenant une première couche de type P (115) en silicium amorphe dopé et un substrat de silicium cristallin (112) dopé de type N disposé entre une première couche de silicium amorphe intrinsèque (113) et une deuxième couche de silicium amorphe intrinsèque (114),
- une couche de jonction (120),
- une deuxième cellule solaire (130) de type pérovskite comprenant une deuxième couche de type P (132), une couche active (131) en un matériau pérovskite et une couche de type N (133),
**caractérisée en ce que** la couche de jonction (120) est en oxyde transparent conducteur (TCO),
et **en ce que** la couche de jonction (120) est en contact avec la deuxième couche de silicium amorphe intrinsèque (114) de la première cellule solaire (110) et avec la deuxième couche de type P (132) de la deuxième cellule solaire (130),
la couche de jonction (120) jouant le rôle de couche de type N dans la première cellule solaire (110).

2. Structure tandem (100) selon la revendication 1, **caractérisée en ce que** la couche de jonction (120) est en ITO.

3. Structure tandem (100) selon la revendication 1, **caractérisée en ce que** la couche de jonction (120) est en AZO, ZnO, IWO, IZO, IZrO ou SnO₂₋ₓ avec x supérieur à 0 et strictement inférieur à 2.

4. Structure tandem (100) selon l'une quelconque des revendications précédentes, **caractérisée en ce que** la couche de jonction (120) a une épaisseur de 2 à 30 nm et de préférence entre 2nm et 15nm.

5. Structure tandem (100) selon l'une quelconque des revendications précédentes, **caractérisée en ce que** la couche de jonction (120) a une conductivité supérieure à 10 S.cm⁻¹.

6. Structure tandem (100) selon l'une quelconque des revendications précédentes, **caractérisée en ce que** la structure tandem (100) comprend depuis la face arrière vers la face avant :
- la première cellule solaire (110) à hétérojonction de silicium à base de silicium amorphe et de silicium cristallin comprenant depuis la face arrière vers la face avant : la première couche de type P en silicium amorphe dopé (115), la première couche de silicium amorphe intrinsèque (113), le substrat de silicium cristallin (112) dopé N et la deuxième couche de silicium amorphe intrinsèque (114),
- la couche de jonction (120) en TCO de type N,
- la deuxième cellule solaire (130) de type pérovskite comprenant depuis le matériau de jonction vers la face avant : une couche de type P (132) en PTAA ou en TFB, la couche active (131) en un matériau pérovskite et une couche (133) de type N en SnO₂ ou formée d'un bicouche PCBM/SnO₂.

7. Structure tandem (100) selon l'une quelconque des revendications précédentes, **caractérisée en ce que** le matériau pérovskite a pour formule CsₓFA₁₋ₓPb(I_{1-y}Br_{y})₃ (avec x < 0,20 ; 0 < y < 1).

## Patentansprüche

1. Photovoltaik-Tandemstruktur (100) mit 2-Terminals vom Typ PIN, von der Rückseite zur Vorderseite umfassend:
- eine erste Siliziumsolarzelle (110) mit Heteroübergang, eine erste Schicht vom Typ P (115) aus dotiertem amorphem Silizium umfassend und ein dotiertes kristallines Siliziumsubstrat (112) vom Typ N, das zwischen einer ersten intrinsischen amorphen Siliziumschicht (113) und einer zweiten intrinsischen amorphen Siliziumschicht (114) angeordnet ist,
- eine Verbindungsschicht (120),
- eine zweite Solarzelle (130) vom Typ Perowskit, eine zweite Schicht vom Typ P (132), eine aktive Schicht (131) aus einem Perowskit-Material und eine Schicht vom Typ N (133) umfassend,
**dadurch gekennzeichnet, dass** die Verbindungsschicht (120) aus transparentem leitfähigem Oxid (TCO) besteht,
und dass die Verbindungsschicht (120) mit der zweiten intrinsischen amorphen Siliziumschicht (114) der ersten Solarzelle (110) und mit der zweiten Schicht vom Typ P (132) der zweiten Solarzelle (130) in Kontakt steht,
wobei die Verbindungsschicht (120) als Schicht vom Typ N in der ersten Solarzelle (110) fungiert.

2. Tandemstruktur (100) nach Anspruch 1, **dadurch gekennzeichnet, dass** die Verbindungsschicht (120) aus ITO besteht.

3. Tandemstruktur (100) nach Anspruch 1, **dadurch gekennzeichnet, dass** die Verbindungsschicht (120) aus AZO, ZnO, IWO, IZO, IZrO oder SnO₂₋ₓ mit x größer als 0 und streng kleiner als 2 besteht.

4. Tandemstruktur (100) nach einem der vorhergehenden Ansprüche, **dadurch gekennzeichnet, dass** die Verbindungsschicht (120) eine Dicke von 2 bis 30 nm aufweist, und vorzugsweise zwischen 2 nm und 15 nm.

5. Tandemstruktur (100) nach einem der vorhergehenden Ansprüche, **dadurch gekennzeichnet, dass** die Verbindungsschicht (120) eine Leitfähigkeit aufweist, die höher als 10 S.cm⁻¹ ist.

6. Tandemstruktur (100) nach einem der vorhergehenden Ansprüche, **dadurch gekennzeichnet, dass** die Tandemstruktur (100) von der Rückseite zur Vorderseite umfasst:
- die erste Siliziumsolarzelle (110) mit Heteroübergang auf Basis von amorphem Silizium und kristallinem Silizium, von der Rückseite zur Vorderseite umfassend: die erste Schicht vom Typ P aus dotiertem amorphem Silizium (115), die erste intrinsische amorphe Siliziumschicht (113), das N-dotierte kristalline Siliziumsubstrat (112) und die zweite intrinsische amorphe Siliziumschicht (114),
- die Verbindungsschicht (120) aus TCO vom Typ N,
- die zweite Solarzelle (130) vom Typ Perowskit, vom Verbindungsmaterial zur Vorderseite umfassend: eine Schicht vom Typ P (132) aus PTAA oder TFB, die aktive Schicht (131) aus Perowskit-Material und eine Schicht vom Typ N (133), die aus SnOz gebildet ist oder aus einer Doppelschicht PCBM/SnOz.

7. Tandemstruktur (100) nach einem der vorhergehenden Ansprüche, **dadurch gekennzeichnet, dass** das Perowskit-Material die Formel CsₓFA₁₋ₓPb(I_{1-y}Br_{y})₃ hat, (mit x < 0,20; 0 < y < 1).

## Claims

1. A tandem photovoltaic structure (100) with 2 PIN-type terminals comprising from the rear face to the front face:
- a first solar cell (110) with a silicon heterojunction comprising a first P-type doped amorphous silicon layer (115) and an N-type doped crystalline silicon substrate (112) disposed between a first intrinsic amorphous silicon layer (113) and a second intrinsic amorphous silicon layer (114),
- a junction layer (120),
- a second perovskite-type solar cell (130) comprising a second P-type layer (132), an active layer (131) made of a perovskite material and an N-type layer (133),
**characterised in that** the junction layer (120) is made of transparent conductive oxide (TCO),
and **in that** the junction layer (120) is in contact with the second intrinsic amorphous silicon layer (114) of the first solar cell (110) and with the second P-type layer (132) of the second solar cell (130),
the junction layer (120) acting as an N-type layer in the first solar cell (110).

2. The tandem structure (100) according to claim 1, **characterised in that** the junction layer (120) is made of ITO.

3. The tandem structure (100) according to claim 1, **characterised in that** the junction layer (120) is made of AZO, ZnO, IWO, IZO, IZrO or SnO₂₋ₓ with x greater than 0 and strictly less than 2.

4. The tandem structure (100) according to any one of the preceding claims, **characterised in that** the junction layer (120) has a thickness of 2 to 30 nm and preferably between 2 nm and 15 nm.

5. The tandem structure (100) according to any one of the preceding claims, **characterised in that** the junction layer (120) has a conductivity greater than 10 S.cm⁻¹.

6. The tandem structure (100) according to any one of the preceding claims, **characterised in that** the tandem structure (100) comprises from the rear face to the front face:
- the first solar cell (110) with a silicon heterojunction based on amorphous silicon and crystalline silicon comprising from the rear face to the front face: the first P-type doped amorphous silicon layer (115), the first intrinsic amorphous silicon layer (113), the N-doped crystalline silicon substrate (112) and the second intrinsic amorphous silicon layer (114),
- the junction N-type TCO layer (120),
- the second perovskite-type solar cell (130) comprising from the junction material to the front face: a P-type PTAA or TFB layer (132), the active layer (131) made of a perovskite material and a N-type layer (133) made of SnOz or formed from a PCBM/SnO₂ bilayer.

7. The tandem structure (100) according to any one of the preceding claims, **characterised in that** the perovskite material has the formula CsₓFA₁₋ₓPb(I_{1-y}Br_{y})₃ (with x < 0.20; 0 < y < 1).
